# EUROPEAN PATENT APPLICATION

(11) **EP 1 720 246 A2**
(43) Date of publication of application: **08.11.2006**
(21) Application number: 06008778.0
(22) Date of filing: 27.04.2006
(51) Int. Cl.: H03B 5/04, H03B 5/36

(54) **Piezoelectric oscillation circuit**

(30) Priority: 28.04.2005 JP 2005133547
(71) Applicant: Epson Toyocom Corporation, Saiwai-ku Kawasaki-shi Kanagawa 212-8513 (JP)
(72) Inventor: Yamamoto, Takahiro, Kamiina-gun Nagano-ken 399-4696 (JP)
(74) Representative: HOFFMANN EITLE

(57) **Abstract**

A piezoelectric oscillation circuit includes: a DC power supply; a stabilized power supply that stabilizes a voltage variation in a DC voltage supplied from the DC power supply; an oscillation circuit unit that uses a piezoelectric vibrator as a vibratory source; a buffer circuit unit to which an output signal output from the oscillation circuit unit is input, a plurality of stages of inverter circuits are connected in series, and a depletion type MOS transistor is connected to the last stage inverter circuit; an output amplification circuit that amplifies an output of the buffer circuit; an output level adjustment circuit that includes a plurality of MOS switches and resistive elements and adjusts an output level by varying a gate voltage of an Nch-transistor included in the output amplification circuit; a memory circuit that stores data for selecting one of the plurality of MOS switches; and a decoder that generates an analog signal to be input to the MOS switch on the basis of the data stored in the memory circuit.

## Description

### BACKGROUND

### 1. Technical Field

The present invention relates to a piezoelectric oscillation circuit, in particular, to a piezoelectric oscillation circuit suitable for use in a low power consumption type temperature compensated crystal oscillator (TCXO).

### 2. Related Art

Recently, a mobile device, such as a mobile phone, for mobile communication has been requested to be reduced in size and weight and a crystal oscillation circuit which has been used as a frequency reference of the mobile device has also been requested to be reduced in size.

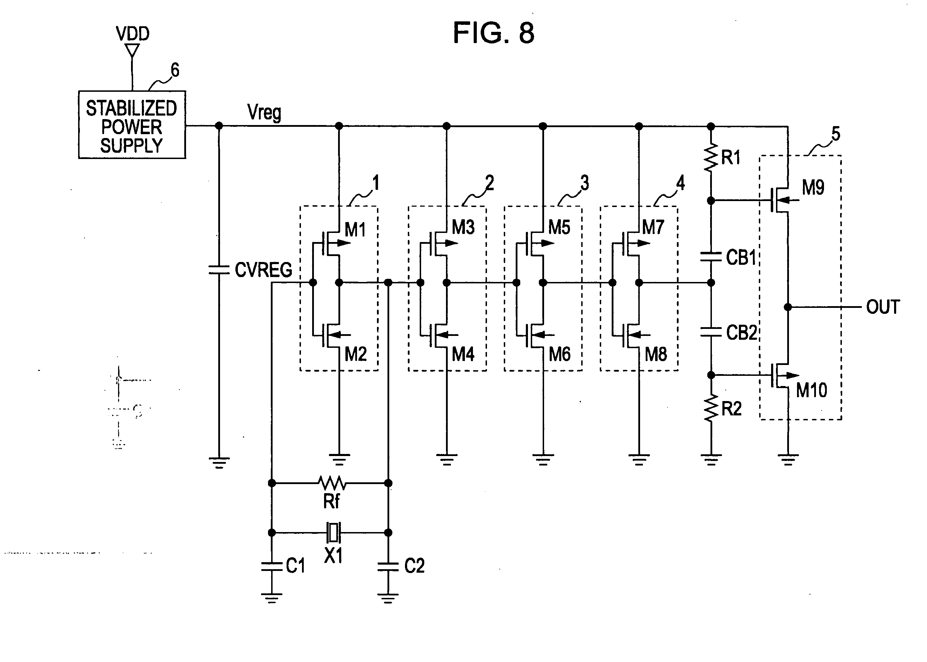

Fig. 8 is a view illustrating an example of a circuit configuration in a crystal oscillation circuit according to the related art.

In Fig. 8, reference numeral X1 represents a crystal vibrator, reference numeral Rf represents a high-frequency resistor, reference numerals C1 and C2 represent oscillation capacitors, reference numeral 1 represents an oscillation amplification circuit, reference numeral 2 represents a first buffer circuit (first-stage buffer circuit), reference numeral 3 represents a second buffer circuit (second-stage buffer circuit), reference numeral 4 represents a third buffer circuit (third-stage buffer circuit), reference numerals R1 and R2 represent resistors, reference numerals CB1 and CB2 represent capacitors, reference numeral 5 represents an output amplification circuit, reference numeral 6 represents a stabilized power supply, reference numeral Cvreg represents a bypass capacitor, and reference numeral Vreg represents reference voltage output from the stabilized power supply 6.

The oscillation amplification circuit 1 is an inverter amplifier which includes a P-channel (hereinafter, referred to as 'Pch') CMOS transistor M1 and an N-channel (hereinafter, referred to as 'Nch') CMOS transistor M2. The first buffer circuit 2 is an inverter amplifier which includes a Pch-CMOS transistor M3 and an Nch-CMOS transistor M4. The second buffer circuit 3 is an inverter amplifier which includes a Pch-CMOS transistor M5 and an Nch-CMOS transistor M6. The third buffer circuit 4 is an inverter amplifier which includes a Pch-CMOS transistor M7 and an Nch-CMOS transistor M8. In addition, the output amplification circuit 5 is a CMOS push-pull amplifier which includes an Nch-MOS transistor M9 and a Pch-CMOS transistor M10.

In Fig. 8, an output of the oscillation amplification circuit 1 is amplified to a desired amplitude for the first buffer circuit 2, corrugated in the second and third buffer circuits 3 and 4, and applied to each gate of the Nch-MOS transistor M9 and the Pch-CMOS transistor M10 of the output amplification circuit 5 through the capacitors CB1 and CB2.

The output amplification circuit 5 supplies an output current to a load capacitor through an output terminal (OUT terminal) at a low impedance. The stabilized power supply 6 supplies the reference voltage Vreg to each position of the above-described circuits. The bypass capacitor Cvreg is connected between an output line of the stabilized power supply 6 and a ground (GND) so as to remove high-frequency noise of the stabilized power supply 6.

A crystal oscillation circuit according to the related art is disclosed in JP-A-2002-261545, for example.

However, in the crystal oscillation circuit shown in Fig. 8, the stabilized power supply 6 is provided to suppress variation of an oscillation output caused by variation of a power supply voltage so as to operate the oscillation circuit by using the reference voltage Vreg generated by the stabilized power supply 6. In addition, the bypass capacitor Cvreg is provided to prevent the high-frequency noise between the reference voltage Vreg and the ground (GND) so as to stabilize the reference voltage Vreg.

However, as the size of a device employing the crystal oscillation circuit is reduced, it is requested that the packaging density of a substrate in which parts of the device are mounted should be increased. In this case, it is difficult to sufficiently secure a space for mounting the bypass capacitor Cvreg that is to be inserted in the output line of the stabilized power supply 6. If the bypass capacitor Cvreg is not provided so as to respond to the request of reducing the size, high-frequency spectrum components unnecessary for the oscillation output may be generated. In addition, since an oscillation output signal becomes easily phase-modulated by the noise generated in the stabilized power supply 6, there is a problem that noise floor of the phase noise characteristic is deteriorated.

Here, the applicant of the invention proposes a crystal oscillation circuit that reduces the dimensional size of a bypass capacitor to be inserted in an output line of a stabilized power supply, stabilizes a reference voltage Vreg output from the stabilized power supply while not increasing an operational speed of the stabilized power supply even when the bypass capacitor is not provided, and suppresses the noise floor of the phase noise characteristic by reducing the sensitivity of the phase modulation caused by the noise generated in the stabilized power supply (refer to JP-A-2004-255119).

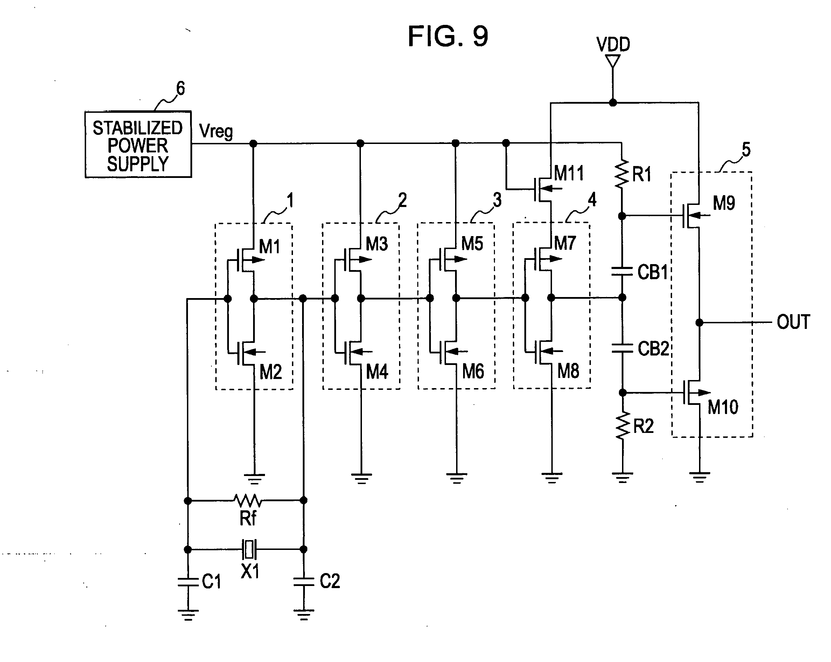

Fig. 9 is a view illustrating a circuit configuration of the crystal oscillation circuit proposed by the applicant of the invention. In addition, the same parts of the crystal oscillation circuit shown in Fig. 8 are represented by the same reference numerals, and the descriptions thereof will be omitted.

In Fig. 9, reference numeral VDD represents a DC power supply and reference numeral M11 represents a depletion type MOS transistor. In the crystal oscillation circuit shown in Fig. 9, a source of the Pch-CMOS transistor M7 included in the third buffer circuit 4 is connected to a source of the depletion type MOS transistor M11, a drain of the depletion type MOS transistor M11 is connected to the DC power supply VDD, and a gate of the depletion type MOS transistor M11 is connected to the stabilized power supply 6, respectively. In addition, a drain of the Nch-MOS transistor M9 included in the output amplification circuit 5 is connected to the DC power supply VDD.

The crystal oscillation circuit configured as described above reduces the dimensional size of the bypass capacitor so as to stabilize the reference voltage Vreg by operating the third buffer circuit 4 and the output amplification circuit 5 in accordance with the DC voltage Vdd from the DC power supply VDD and operating the oscillation amplification circuit 1 and the first and second buffer circuits 2 and 3 in accordance with the stabilized power supply 6. In addition, the crystal oscillation circuit stabilizes the reference voltage Vreg while not increasing the operational speed of the stabilized power supply 6 even when the bypass capacitor is not provided.

In addition, it is possible to suppress the noise floor of the phase noise characteristic to be low by reducing the sensitivity of the phase-modulation caused by the noise generated in the stabilized power supply 6.

However, recently, a plurality of conditions are requested of the low power consumption type temperature compensated crystal oscillator (TCXO) which is used as a reference oscillation source of a mobile phone. It is necessary to suppress the oscillation output voltage amplitude to be low so as to correspond to the low power consumption, or the output amplitude should be large so as to drive an IC located at an end-stage of the TCXO. That is, the output amplitude of the oscillator should be optimized according to the selected a purpose. However, it is difficult to arbitrarily select or adjust the amplitude of the oscillation output voltage by using the configuration of the circuit disclosed in JP-A-2004-255119.

### SUMMARY

An advantage of some aspects of the invention is that it provides a piezoelectric oscillation circuit capable of obtaining oscillation characteristic stabilized in a wide power supply voltage range and adjusting the amplitude of an oscillation output.

According to an aspect of the invention, a piezoelectric oscillation circuit includes: a DC power supply; a stabilized power supply that stabilizes a voltage variation in a DC voltage supplied from the DC power supply; an oscillation circuit unit that uses a piezoelectric vibrator as a vibratory source; a buffer circuit unit to which an output signal output from the oscillation circuit unit is input, a plurality of stages of inverter circuits are connected in series, and a depletion type MOS transistor is connected to the last stage inverter circuit; an output amplification circuit that amplifies an output of the buffer circuit; an output level adjustment circuit that includes a plurality of MOS switches and resistive elements and adjusts an output level by varying a gate voltage of an Nch-transistor included in the output amplification circuit; a memory circuit that stores data for selecting one of the plurality of MOS switches; and a decoder that generates an analog signal to be input to the MOS switch on the basis of the data stored in the memory circuit.

In the piezoelectric oscillation circuit, preferably, the output level adjustment circuit is configured such that the output level output from the output amplification circuit can be set with three stages.

Further, in the piezoelectric oscillation circuit, it is preferable that the piezoelectric vibrator be a crystal vibrator.

According to the invention, since the last stage inverter circuit of the buffer circuit and the output amplification circuit are operated by the DC power supply so as to operate the inverter circuit excepting for the oscillation circuit unit and the last stage of the buffer circuit by using the stabilized power supply, it is possible to stabilize a reference voltage output from the stabilized power supply without raising an operational speed of the stabilized power supply or using a bypass capacitor as in the related art. That is, since the bypass capacitor can be reduced in size or a power supply noise generated in the reference voltage which is not used can be suppressed to be less than a level according to the related art, it is possible to realize a small piezoelectric oscillation circuit having desired phase noise characteristic.

In addition, since the amplitude of the oscillation output is configured to be arbitrarily adjusted, it is possible, for example, to variably correspond in accordance to a request of the output amplitude level of the TCXO which has been used as a reference oscillation source for a mobile phone and it is also possible to provide the TCXO having low power consumption in accordance with the setting of the output level.

### BRIEF DESCRIPTION OF THE DRAWINGS

The invention will be described with reference to the accompanying drawings, wherein like numbers reference like elements.

Fig. 1 is a circuit diagram illustrating a crystal oscillation circuit serving as a piezoelectric oscillation circuit according to an embodiment of the present invention.

Fig. 2 is a comparative view illustrating power supply voltage characteristic of a frequency.

Fig. 3 is a comparative view illustrating power supply voltage characteristic of an oscillation output.

Fig. 4 is a view illustrating voltage waveforms of operation points A, B, C, and D of the crystal oscillation circuit according to an embodiment.

Fig. 5 is a comparative view illustrating phase noise characteristic of the crystal oscillation circuit according to the embodiment and the crystal oscillation circuit according to the related art.

Fig. 6 is a view illustrating the relationship between an output level set and an output waveform of an output terminal in the crystal oscillation circuit according to the embodiment.

Fig. 7 is a circuit diagram illustrating a crystal oscillation circuit according to another embodiment of the invention.

Fig. 8 is a circuit diagram illustrating a crystal oscillation circuit according to related art.

Fig. 9 is a circuit diagram illustrating a crystal oscillation circuit proposed beforehand by the applicant of the invention.

### DESCRIPTION OF EXEMPLARY EMBODIMENTS

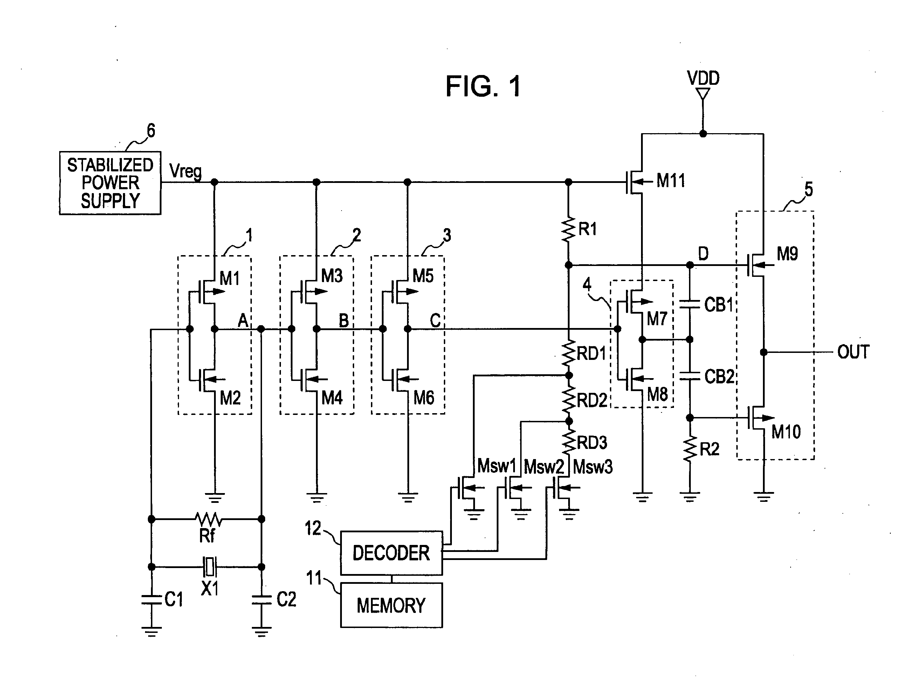

Fig. 1 is a circuit diagram illustrating a crystal oscillation circuit serving as a piezoelectric oscillation circuit according to an embodiment of the invention.

In addition, parts of the crystal oscillation circuit having the same functions as in Figs. 8 and 9 are represented by the same reference numerals, and the descriptions thereof will be omitted.

In Fig. 1, reference numeral A represents an output terminal of an oscillation amplification circuit 1, reference numeral B represents an output terminal of a first buffer circuit 2, and reference numeral C represents an output terminal of a second buffer circuit 3.

An output line of a stabilized power supply 6 is connected to a gate of a depletion type MOS transistor M11 and each source of a Pch-CMOS transistor M1 of the oscillation amplification circuit 1, a Pch-CMOS transistor M3 of the first buffer circuit 2, and a Pch-CMOS transistor M5 of the second buffer circuit 3, respectively.

In addition, this embodiment shows an example that the oscillation amplification circuit 1 is configured by using an inverter amplifier. However, the embodiment is not limited to the inverter circuit but the oscillation amplification circuit 1 may be configured by using, for example, a bipolar transistor. In this case, a DC-blocking capacitor should be inserted to an input part of the first buffer circuit 2 indicated by point A in Fig. 1 and a feedback bias resistor having high-resistance should be inserted between input and output parts.

In addition, an output line of a DC power supply VDD is connected to the drain of the depletion type MOS transistor M11 and a drain of an Nch-MOS transistor M9.

With the above-described configuration, if a reference voltage output from a stabilized power supply 6 is set to Vreg and a voltage between gate sources of the MOS transistor M11 is set to VGS_{M11}, an output amplitude of a third buffer circuit 4 becomes Vreg - VGS_{M11}. However, since the MOS transistor M11 is the depletion type MOS transistor, if, for example, the reference voltage Vreg of the stabilized power supply 6 is set to 2.1 V, the output amplitude of the third buffer circuit 4 becomes approximately 1.9 Vp-p.

An inverter output signal output from the third buffer circuit 4 is DC blocked by capacitors CB1 and CB2 and applied to gates of the Nch-MOS transistor M9 and the Pch-CMOS transistor M10 of an output amplification circuit 5 connected to the other ends of the capacitors CB1 and CB2, respectively.

In addition, in this case, the voltage at point D, that is, a gate voltage VG_{M9} of the Nch-MOS transistor M9, is determined by dividing the resistance of resistors R1 and RD1 to RD3. If the Nch-MOS transistor M9 is turned on, the voltage VGS between the gate sources of the Pch-CMOS transistor M10 becomes low to be cut off.

Accordingly, it is possible to hold the amplitude of the output voltage output last from the output amplification circuit 5 constant without depending on a power supply voltage by using a relation 'VG_{M9} - VGS_{M9}' between the gate voltage VG_{M9} of the Nch-MOS transistor M9 and the voltage VGS_{M9} between the gate sources.

For example, when it is assumed that the reference voltage Vreg is set to 2.1 V and the gate voltage VG_{M9} of the Nch-MOS transistor M9 is set to 1.8 V, if the voltage between the gate sources is VGS_{M9} ≅ 0.8 V, a constant output amplitude of 1.0 Vp-p can be obtained even though it depends on a driving force of the Nch-MOS transistor M9.

In addition, in the crystal oscillation circuit according to this embodiment, since the oscillation amplification circuit 1 and the first and second buffer circuits 2 and 3 are driven by the stabilized power supply 6, it is possible to suppress the frequency variation to be extremely small. At this time, if the DC voltage Vdd of the DC power supply VDD becomes low, a transistor of the stabilized power supply 6 is operated in a saturation region. If a condition of the DC voltage Vdd - the reference voltage Vreg ≥ 0.2 V is satisfied, a stabilized output signal can be obtained within a wide power supply voltage range. For example, in the case of the reference voltage Vreg = 2.1 V, the crystal oscillation circuit can be stabilized and operated to the DC voltage Vdd = 2.3 V.

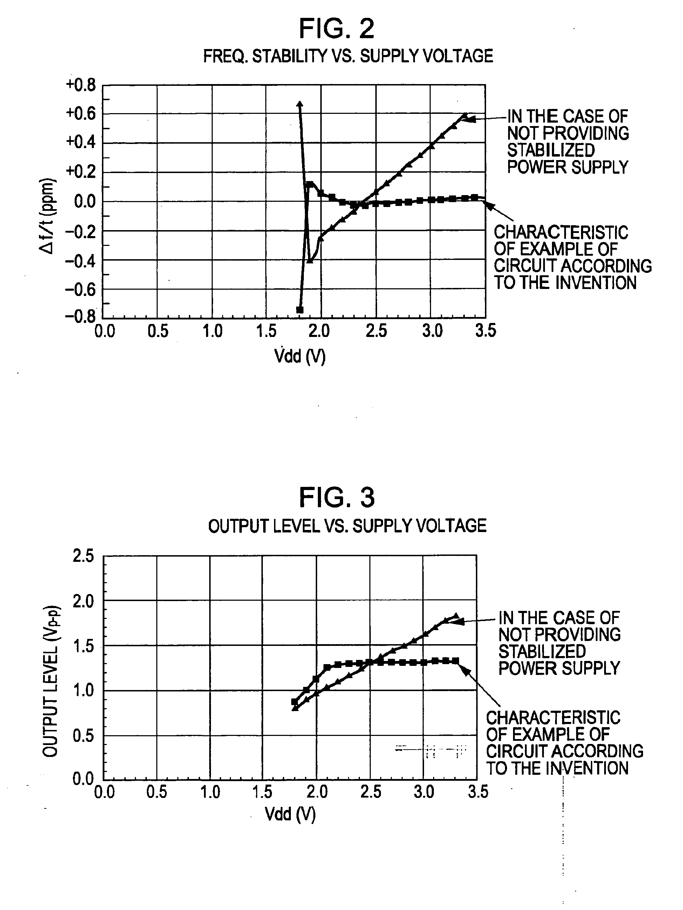

Fig. 2 is a view illustrating the relationship between an oscillation frequency and the power supply in the crystal oscillation circuit according to this embodiment. Fig. 3 is a view illustrating the relationship between an output level and the power supply. As can be seen in Figs. 2 and 3, in the crystal oscillation circuit according to this embodiment, since the high frequency accuracy can be obtained within a wide range of the DC voltage Vdd, it is understood that the oscillation output level is extremely stable.

In this embodiment, the DC power supply VDD supplies a current to be supplied from the output amplification circuit 5 to a load capacitor connected to an output terminal (OUT terminal) and a current to be supplied from the third buffer circuit 4 to the capacitors CB1 and CB2 without using the stabilized power supply 6.

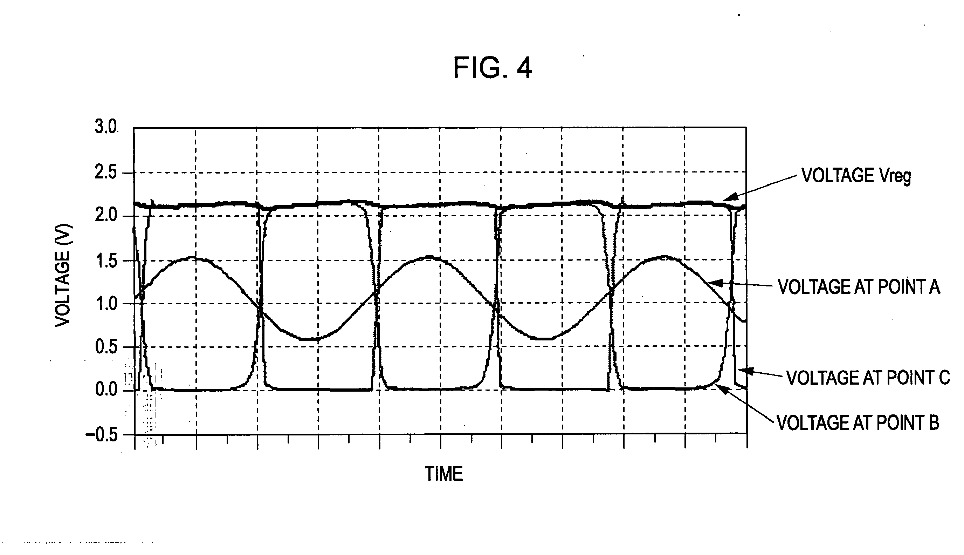

Accordingly, if a signal level of point C shown in Fig. 1 becomes a 'low' level with respect to a threshold level of the third buffer circuit 4, since the third buffer circuit 4 and the output amplification circuit 5 do not receive a large current from the stabilized power supply 6, the load of the stabilized power supply 6 which generates the reference voltage Vreg can be reduced and voltage waveforms of operation points A, B, and C become as shown in Fig. 4. Accordingly, it is possible to stabilize the reference voltage Vreg of the stabilized power supply 6.

According to the above-described configuration, it is possible to remove unnecessary spectrum components from the oscillation output signal and the amplitude is hardly modified by the noise generated in the stabilized power supply 6. Since the sensitivity of the phase modulation caused by the noise of the noise floor reference voltage Vreg which is a phase noise characteristic can be suppressed, it is possible to substantially improve the phase noise floor.

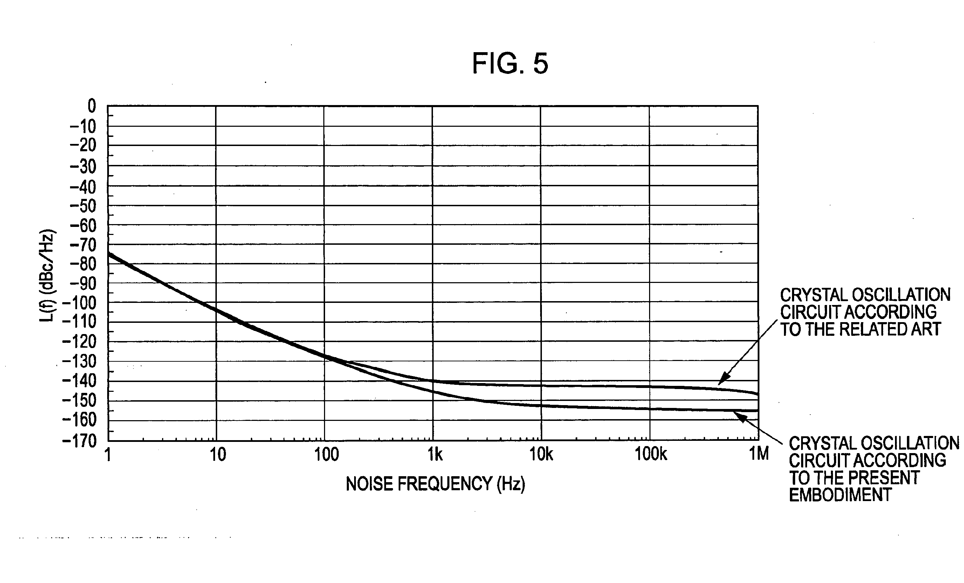

Fig. 5 is a comparative view illustrating the phase noise characteristic of the crystal oscillation circuit according to this embodiment and the crystal oscillation circuit according to the related art. In the crystal oscillation circuit according to this embodiment shown in Fig. 5, it is possible to improve the phase noise characteristic by about 10 dB in a detuning frequency which is more than 10 kHz.

In addition, the crystal oscillation circuit according to this embodiment provides MOS switches MSW1, MSW2, and MSW3 serving as the output level adjustment circuit which adjusts the output level by varying the gate voltage of the Nch-CMOS transistor M9 forming the output amplification circuit 5, as shown in Fig. 1. The MOS switches MSW1, MSW2, and MSW3 are provided between a connection point of the resistors RD1 and RD2 and a ground potential, between a connection point of the resistors RD2 and RD3 and a ground potential, and between the resistors RD3 and a ground potential, respectively. Accordingly, it is possible to adjust a voltage at a point D determined by dividing the resistances of resistors R1 and RD1 to RD3 in three stages by selecting and turning on any one of the MOS switches MSW1 to MSW3. Since adjusting the voltage at point D has the same effect as adjusting the gate voltage VG_{M9} of the MOS transistor M9, the output amplitude can be adjusted by using a relational expression of the output voltage Vout = (VG_{M9} - VGS_{M9}) .

At this time, data for selecting and turning on any one of the MOS switches MSW1 to MSW3 is stored in a memory circuit 11, and a decoder 12 decodes the data stored in the memory circuit 11 so as to determine the switch to be turned on.

For example, when the data for only turning on the MOS switch MSW1 is stored in the memory circuit 11 and the MOS switch MSW1 is turned on (electrically conducted), the voltage at the point D is obtained by dividing the resistance of the resistors R1 and RD1. However, since the point D is connected to a ground through only the resistor RD1, the voltage drops more than a voltage obtained by dividing the resistance of the resistors R1 when the MOS switch MSW2 is turned on, and the sum of the resistances of the resistors RD1 and RD2. In this embodiment, the resistor RD1 is set to have a resistance ratio in which a voltage of about 0.2 V drops.

Since the voltage when the MOS switch MSW1 is selected becomes about 1.6 V, if the voltage at point D is set to 1.8 V when the MOS switch MSW2 is turned on, the output amplitude becomes about 0.8 Vp-p by using the relational expression of the output voltage Vout = (VG_{M9} - VGS_{M9}).

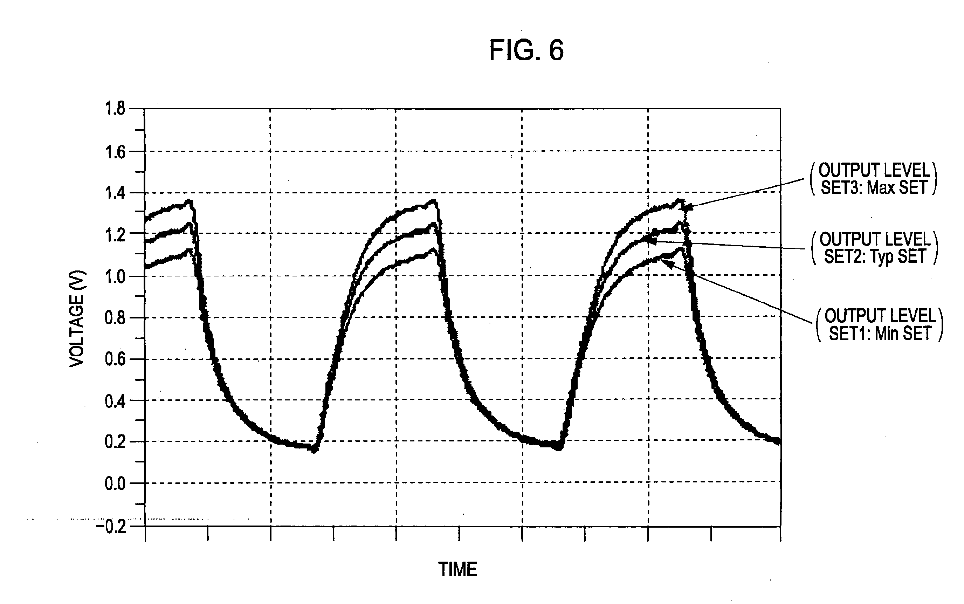

In addition, the resistors RD1 to RD3 are respectively set so that the output amplitude becomes 1.0 Vp-p when the MOS switch MSW2 is selected, and so that the output amplitude becomes 1.2 Vp-p when the MOS switch MSW3 is selected. That is, the output level becomes a set1 (Min set) when selecting the MOS switch MSW1, the output level becomes a set2 (Typ set) when selecting the MOS switch MSW2, and the output level becomes a set3 (Max set) when selecting the MOS switch MSW1. Fig. 6 shows an output waveform in accordance with each of the output level sets selected.

In the crystal oscillation circuit according to this embodiment, it is possible to arbitrarily adjust the oscillation output amplitude by storing information for selecting a desired resistor among the divided resistors RD1 to RD3 and setting the selected resistor to a desired output level in the memory circuit 11 and electrically conducting or electrically disconnecting the desired MOS switch in accordance with an analog signal decoded by the decoder 12 based on the information stored in the memory circuit 11.

Accordingly, it is possible to variably correspond in accordance to a request of the output amplitude level of the TCXO which has been used as a reference oscillation source for a mobile phone and it is also possible to provide the TCXO having low power consumption in accordance with the selected setting of the output level. Further, when shipping the crystal oscillation circuit as a real oscillator, the information stored in the memory circuit 11 should be determined beforehand and the output level thereof may not be arbitrarily selected after the shipping.

In addition, in the crystal oscillation circuit according to this embodiment, the output level can be selected with the three stages but it is only an example. For example, the output level can be selected with various stages other than the three stages by increasing the number of resistors RD and the number of MOS switches corresponding to the resistors RD.

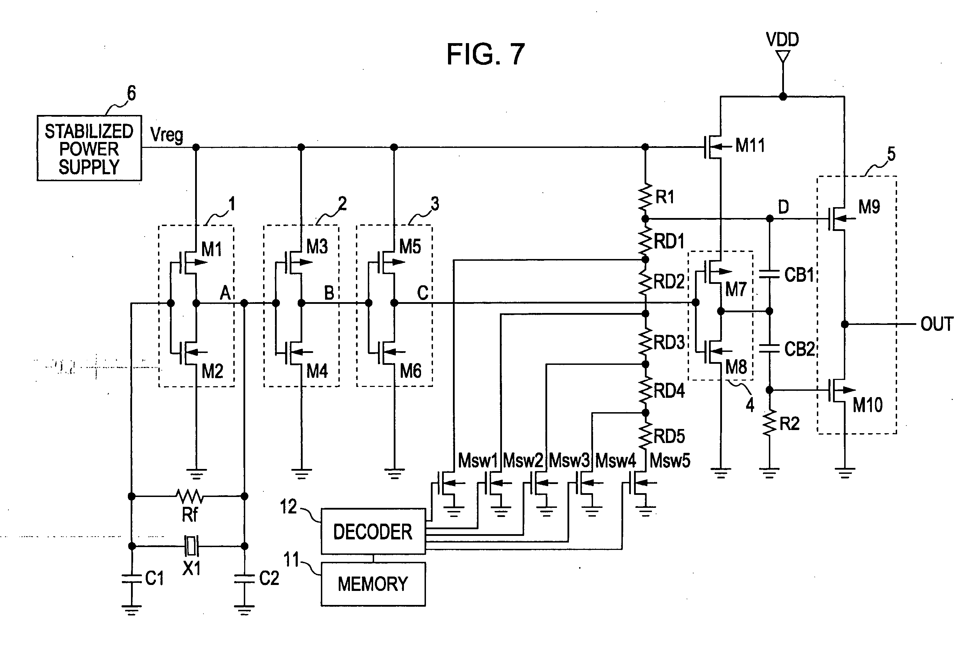

Fig. 7 is a circuit diagram illustrating a crystal oscillation circuit according to another embodiment of the invention.

In the crystal oscillation circuit shown in Fig. 7, the output level can be selected through five stages. In this case, the output level becomes a set1 (Min set) when selecting the MOS switch MSW1, the output level becomes a set3 (Typ set) when selecting the MOS switch MSW3, and the output level becomes a set5 (Max set) when selecting the MOS switch MSW3.

In addition, in the crystal oscillation circuit shown in Figs. 1 and 7, as a circuit configuration for adjusting the voltage between the gate of the MOS transistor M9 and the ground, the circuit configured to bypass the connection points of the resistors RD1 to RD5 and grounds by using the MOS switch has been described. However, it can be configured to bypass the connection point of the MOS transistor M9 and a gate by the MOS switch.

Further, in the crystal oscillation circuit shown in Figs. 1 and 7, as a circuit configuration for adjusting the voltage between the gate of the MOS transistor M9 and the ground, a circuit including the MOS switch so as to adjust a value of resistance between the gate of the MOS transistor M9 and the ground has been described. While providing a resistive network connecting a plurality of resistors in series instead of the resistor R1 shown in Figs. 1 and 7, the crystal oscillation circuit can be configured with a MOS switch which bypasses between the connection points of the resistors and the stabilized power supply 6 or between the connection points of the resistors and the gate of the MOS transistor M9, a decoder for controlling to turn on/off the MOS switch, and a memory.

Furthermore, the crystal oscillation circuit can be configured by controlling the value of the resistance between the gate of the MOS transistor M9 and the ground while controlling the value of the resistance between the gate of the MOS transistor M9 and the stabilized power supply 6. In this case, it is possible to precisely adjust a gate potential of the MOS transistor M9.

## Claims

1. A piezoelectric oscillation circuit comprising:
a DC power supply;
a stabilized power supply that stabilizes a voltage variation in a DC voltage supplied from the DC power supply;
an oscillation circuit unit that uses a piezoelectric vibrator as a vibratory source;
a buffer circuit unit to which an output signal output from the oscillation circuit unit is input, a plurality of stages of inverter circuits are connected in series, and a depletion type MOS transistor is connected to the last stage inverter circuit;
an output amplification circuit that amplifies an output of the buffer circuit;
an output level adjustment circuit that includes a plurality of MOS switches and resistive elements and adjusts an output level by varying a gate voltage of an Nch-transistor included in the output amplification circuit;
a memory circuit that stores data for selecting one of the plurality of MOS switches; and
a decoder that generates an analog signal to be input to the MOS switch on the basis of the data stored in the memory circuit.

2. The piezoelectric oscillation circuit according to Claim 1,
wherein the output level adjustment circuit is configured such that the output level output from the output amplification circuit can be set with three stages.

3. The piezoelectric oscillation circuit according to Claim 1,
wherein the piezoelectric vibrator is a crystal vibrator.
